# EUROPÄISCHE PATENTSCHRIFT

(11) **EP 2 411 191 B1**
(45) Veröffentlichungstag und Bekanntmachung des Hinweises auf die Patenterteilung: **28.08.2013**
(21) Anmeldenummer: 09775852.8
(22) Anmeldetag: 26.03.2009
(51) Int. Cl.: B25J 15/06, B65G 47/91, H01L 21/683

(54) **BERNOULLI-GREIFERVORRICHTUNG MIT MINDESTENS EINEM BERNOULLI-GREIFER**
BERNOULLI GRIPPER APPARATUS HAVING AT LEAST ONE BERNOULLI GRIPPER
DISPOSITIF DE PRÉHENSION SELON BERNOULLI COMPRENANT AU MOINS UNE ORGANE DE PRÉHENSION SELON BERNOULLI

(43) Veröffentlichungstag der Anmeldung: 01.02.2012
(73) Patentinhaber: Jonas & Redmann Automationstechnik GmbH, 10553 Berlin (DE)
(72) Erfinder: MERSCHER, Michael, 13585 Berlin (DE); URIARTE, Claudio, 13355 Berlin (DE)
(74) Vertreter: Hoffmann, Klaus-Dieter
(86) Internationale Anmeldenummer: PCT/DE2009/000424
(87) Internationale Veröffentlichungsnummer: WO 2010/108462

(56) Entgegenhaltungen:
- WO-A-2008/145085
- JP-A- 62 016 945
- JP-A- 2009 032 981
- US-A- 4 474 397

## Beschreibung

Die Erfindung betrifft eine Bernoulli-Greifervorrichtung mit mindestens einem eine rechteckförmige Grundrißkontur aufweisenden Bernoulli-Greifer zur Aufnahme von flächigen Substraten wie siliziumbasierten Wafem.

Eine solche Vorrichtung ist aus der US-A-4 474 397 bekannt.

Bei aus der WO 2008/145085 A1, der EP 1685930 und der US2002/0130524 bekannten Bernoulli-Greifern, die eine kreisförmige Grundrißkontur aufweisen, sowie bei dem aus der US-A-4 747 397 bekannten Bernoulli-Greifer, wird die abströmende Luft stets in radialer Richtung von innen nach außen zur Peripherie des Bernoulli-Greifers befördert. Dies hat zur Folge, dass die Abluft nach außen gedrückt wird und in unmittelbarer Nähe der Peripherie des Bernoulli-Greifers stört. Die bekannten Bernoulli-Greifer sind daher ungeeignet, jeweils für eine beliebigen Mehrfachgreiferkonfiguration verwendet zu werden, wie es z.B. von Vakuumgreifern bekannt ist, da die bei jedem Bernoulli-Greifer einer derartigen beliebigen Mehrfach-Bernoulli-Greiferkonfiguration radial von innen nach außen zur Peripherie des Bernoulli-Greifers transportierte Abluft die an benachbarten Bernoulli-Greifern befindlichen Plättchen, Wafer oder anderen flächigen Substrate beschädigen oder wegblasen würde. Bei der Entladung von dünnen Plättchen aus einer umfangsmäßig geschlossenen Box, z.B. beim Entladen von siliziumbasierten Wafern aus einem Transportcarrier, würde die an der Peripherie eines bekannten Bernoulli-Greifers abströmende Abluft gegen die Innenwand der Box oder des Transportcarriers geleitet und die unter dem zu greifenden Plättchen positionierten Plättchen ebenfalls in Bewegung setzen. Durch diese Bewegung ist die Gefahr einer Beschädigung der Kanten und/oder Oberfläche des Plättchens gegeben.

Aus der JP-A-62016945 ist weiterhin eine Bernoulli-Greifervorrichtung zur Aufnahme von flächigen Substraten bekannt, bei der ein Strömungssystem für Druckluft vorgesehen ist, das von außen nach innen gerichtet ist, wobei die über Austrittsöffnungen abströmende Druckluft in einem zentralen vertikal nach oben gerichteten Abzugsschacht innerhalb der Bernoulli-Greifervorrichtung nach außen geführt wird. Bei letzterer ist in einem Druckrohr mit kreisförmigen Querschnitt koaxial ein mit dem Abzugsschacht kommunizierendes Saugrohr vorgesehen, an dessen Ende, das dem zu greifenden Substrat zugewandt ist, sich vom Umfangsrand ein ebener Abschnitt senkrecht zur Richtung der Strömung im Saugrohr bis zu einem vorragenden Ende des Außenmantels des Druckrohres erstreckt. In dem ebenen Abschnitt sind mit dem Druckrohr kommunizierende Austrittsöffnungen und in dessen Fläche, die dem zu greifenden Substrat zugewandt ist, radial verlaufende Vertiefungskanäle ausgebildet. Wenn ein Substrat dem ebenen Abschnitt angenähert und Luft aus dem Druckrohr über die Austrittsöffnungen abgelassen und zugleich in das Saugrohr gesaugt wird, strömt die Luft infolge der Wirkung der Vertiefungskanäle gleichförmig in dem Spalt, der zwischen dem ebenen Abschnitt und dem Substrat gebildet ist.

Da keine Elemente zum Dämpfen des Substrats bei dessen ansaugbedingter Annäherung an den ebenen Abschnitt vorgesehen sind, ist nicht gewährleistet, dass das Substrat beim Transport in einer stabilen berührungslosen Lage gehalten wird, sondern der Bernoulli-Effekt kann ein Anschlagen des Substrates an dem ebenen Abschnitt verursachen. Die Vertiefungskanäle leiten die Luft zwischen Einström- und Ausströmöffnung selbst dann noch, wenn es zu einem Anliegen des Substrates an den ebenen Abschnitt der Bernoulli-Greifervorrichtung kommt. Um ein schonendes und berührungsloses Handhaben der Substrate zu erreichen, ist bei dieser bekannten Bernoulli-Greifervorrichtung eine komplizierte Steuerung des Luftstroms erforderlich.

Weiterhin ist bei dieser Bernoulli-Greifervorrichtung der Mantel des Druckrohres tiefer über die Ebene nach unten gezogen, in der das Substrats sich in seiner stabil gehaltenen Position liegt. Der Mantel des Druckrohres ist sozusagen über das Substrat in dessen berührungslos gehaltener Lage gestülpt und bildet einen Stopanschlag. Hierdurch wird das Substrat beim Transport vor einem Wegrutschen aus seiner Lage bewahrt und das Substrat kann sich in der entsprechenden Ebene beliebig bewegen. Es jedoch nicht möglich, mit dieser bekannten Bernoulli-Greifervorrichtung Substrate aufzunehmen, die über den Stopanschlag am Mantel des Druckrohres hinausragen. Aber auch zum Handhaben von Substraten, deren Längenabmessungen wesentlich kleiner als der Durchmesser des Druckrohres im Bereich des Stopanschlags sind, ist diese bekannte Bernoulli-Greifvorrichtung ungeeignet, da in diesem Fall ein verhältnismäßig großer Anteil der aus den Austrittsöffnungen im ebenen Abschnitt in den Spalt zwischen dem Substrat und dem ebenen Abschnitt strömenden Luft über den nunmehr vergrößerten Spalt zwischen dem Substratrand und dem Stopanschlag des Druckrohres entweicht und ein Bernoulli-Effekt für ein berührungsloses Halten des Substrats in der gewünschten stabilen Lage nicht erzeugt wird. Zum Handhaben von Substraten mit jeweils unterschiedlichen Längenabmessungen ist daher stets eine andere Bemoulli-Greifvorrichtung mit entsprechenden Abmaßen einzusetzen.

Der Erfindung liegt die Aufgabe zugrunde, eine Bernoulli-Greifervorrichtung der eingangs erwähnten Art zur Verfügung zu stellen, bei der der mindestens eine Bernoulli-Greifer an seiner Peripherie frei von Abluft zu halten ist und die Substrate unabhängig von ihren Längenabmessungen von dem Bernoulli-Greifer ohne Schwierigkeiten anzusaugen sind. Zudem soll die Bernoulli-Greifervorrichtung als Mehrfachgreiferkonfiguration des Bernoulli-Greifers zu gestalten sein.

Diese Aufgabe wird erfindungsgemäß durch die Gesamtheit der Merkmale des Patentanspruchs 1 gelöst.

Vorzugsweise weisen - gesehen im Querschnitt des Bernoulli-Greifers - jedes Greiferkörperelement an seinem dem zu greifenden Substrat zugewandten Ende einen zu diesem rechtwinkligen und zur Längsachse des Bernoulli-Greifers hin gerichteten Kragen und das trichterförmige Bauelement an seinem dem zu greifenden Substrat zugewandten Ende an beiden Längsseiten einen nach außen gerichteten Kragen auf, dessen Ende jeweils oberhalb des Kragen des zugeordneten Greiferkörperelementes derart im Bernoulli-Greifer positioniert ist, dass die jeweils mindestens eine Austrittsöffnung jeder Druckluftkammer zwischen der dem zu greifenden Substrat zugewandten planen Fläche des nach außen gerichteten Kragens des trichterförmigen Bauelementes und der planen Fläche des Kragens des zugeordneten Greiferkörperelementes gebildet ist, die zur Fläche des nach außen gerichteten Kragens des trichterförmigen Bauelementes parallel und dieser zugewandt ist.

An der planen Stirnfläche des Kragens jedes Greifkörperelementes ist geeigneterweise jeweils ein gummiertes Auflageelement mit einer Greiffläche für das zu greifende Substrat vorgesehen, wobei die beiden Greifflächen in einer Ebene A liegen.

Das dem zu greifenden Substrat zugewandte beidseitige Ende des trichterförmigen Bauelementes ist in Bezug zur Ebene A der Greifflächen der Auflageelemente in Richtung senkrecht zur Längsachse des Bernoulli-Greifers in diesen nach innen versetzt angeordnet ist.

Bevorzugt ist - gesehen im Querschnitt des Bernoulli-Greifers - die Oberfläche des dem zu greifenden Substrat zugewandten beidseitigen Endes des trichterförmigen Bauelementes konvex geformt ist und geht konkav geschwungen in die untere Fläche des zugeordneten nach außen gerichteten Kragens des trichterförmigen Bauelementes über. Hierdurch ist bei der durch den Bernoulli-Effekt bedingten Anlage des Substrats an der Greiffläche jedes Auflageelementes jeweils der Druckluftstrom aus der mindestens einen Austrittsöffnung jeder Druckluftkammer an der Fläche des zugeordneten nach außen gerichteten Kragens des trichterförmigen Bauelementes entlang einwärts zur Längsachse des Bernoulli-Greifers hin zur konvex geformten Oberfläche des zugeordneten Endes des trichterförmigen Bauelementes und um letzteres herum in den nach oben offenen Abzugsschacht hinein und im Bernoulli-Greifer aufwärts zu führen sowie aus letzterem abzuführen.

Bei einer bevorzugten Ausführungsform der Bernoulli-Greifervorrichtung ist eine Vielzahl der Bernoulli-Greifer in einer beliebigen Mehrfach- Bemoulli-Greiferkonfiguration angeordnet. Die Vielzahl der Bernoulli-Greifer kann matrixartig an einem Halterungsrahmen vorgesehen sein. Weiterhin können die einzelnen Strömungssysteme der Vielzahl der Bernoulli-Greifer synchron oder asynchron über die jeweiligen Druckluftzuführungen anzusteuern sein. Durch eine derartige Steuerung der Druckluftzuführung in Verbindung mit einer Rückführung der Abluft aus den Bemoulli-Greifem über deren jeweiliges Absaugsystem in das Strömungssystem für die Druckluft der jeweiligen Bernoulli-Greifer ist ein effizienter Einsatz der Bernoulli-Greifervorrichtung gewährleistet.

Mit der erfindungsgemäßen Bernoulli-Greifervorrichtung wird in vorteilhafterweise die Problematik der Aufnahme unterschiedlicher Plättchengeometrien gelöst, indem Ausführungsformen des Bernoulli-Greifers mit rechteckförmiger Grundrißkontur zur Verfügung gestellt werden, die an ihrer Peripherie und dem benachbarten Umfeld letzterer frei von Abluft aus dem Bernoulli-Greifer zu halten sind.

Mit dem mindestens einen Bernoulli-Greifer der erfindungsgemäßen Bernoulli-Greifervorrichtung sind auch flächige Substrate und Gegenstände aus Glas, Keramik, Blech, Holz oder Kunststoff geeignet aufzunehmen und gegebenenfalls schnell zu befördern.

Die Erfindung wird nun anhand der Zeichnungen erläutert. In diesen sind:
**Fig. 1** eine perspektivische Ansicht - gesehen schräg von oben - eines Bernoulli-Greifers mit rechteckförmigem Grundriß,
**Fig. 2** eine Draufsicht des Bernoulli-Greifers nach Figur 1, von dem ein Wafer gegriffen ist,
**Fig. 3** eine Ansicht eines Querschnitts in der Ebene A-A des Bernoulli-Greifers nach Fig. 1,
**Fig. 4** eine der Fig. 2 entsprechende Draufsicht des Bernoulli-Greifers ohne an diesen angelegten Wafer, wobei die Verteilung der Druckluft innerhalb der Bernoulli-Greifers gezeigt ist,
**Fig. 5** eine der Fig. 3 entsprechende Querschnittsansicht des Bernoulli-Greifers mit an diesem angelegten Wafer, wobei die Strömung der Druckluft durch den Bernoulli-Greifer beim Greifvorgang gezeigt ist, und

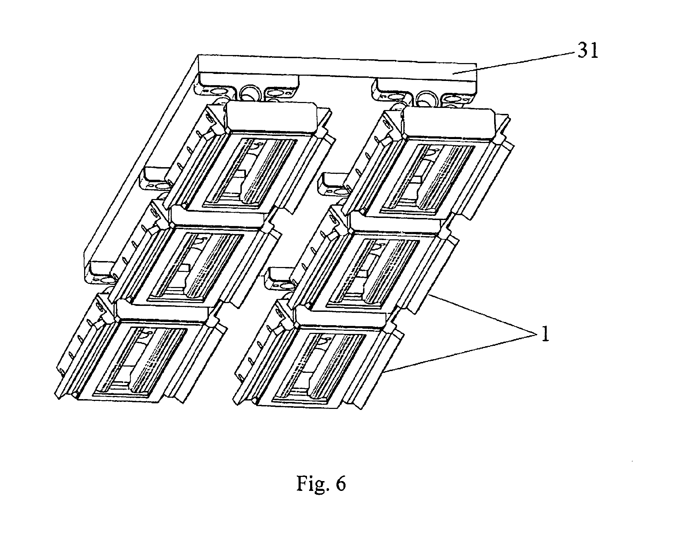

**Fig. 6** eine perspektivische Ansicht - gesehen schräg von unten der Bernoulli-Greifervorrichtung mit einer an einer Halterung vorgesehenen matrixartigen Anordnung von Bemoulli-Greifern der Ausführungsform nach Fig. 1.

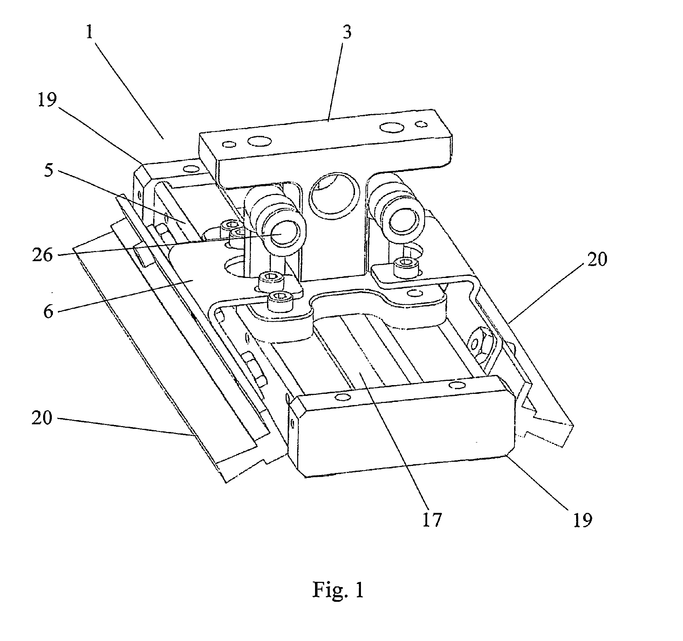

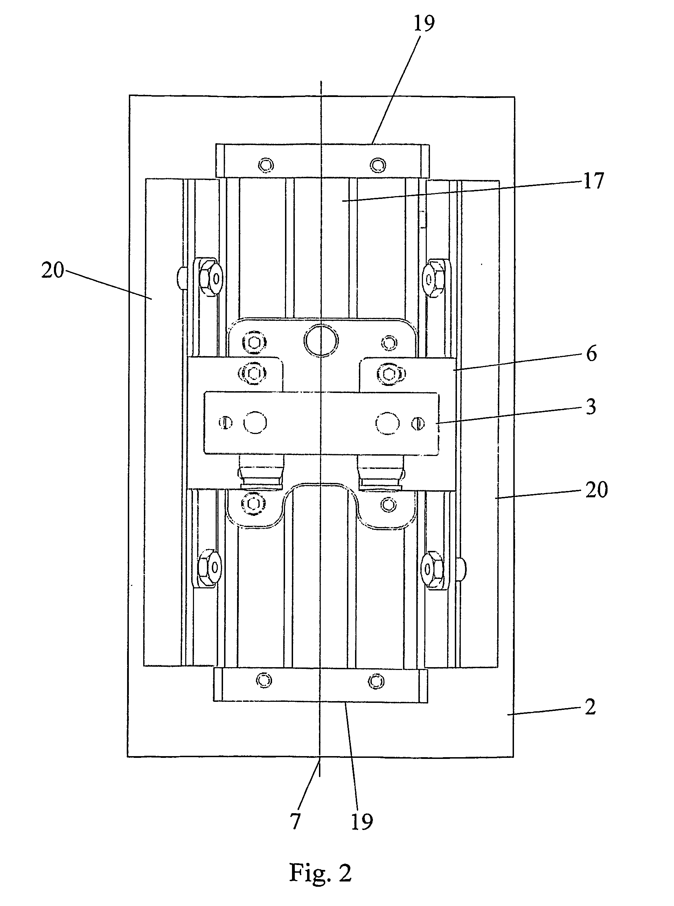

Bei einer Ausführungsform der erfindungsgemäßen Bernoulli-Greifervorrichtung ist, wie aus den Fig. 1, 2 und 4 zu ersehen ist, ein Bernoulli-Greifer 1 mit einer rechteckförmigen Grundrißkontur vorgesehen, von dem flächige Substrate wie siliziumbasierte Wafer 2 aufzunehmen sind. Der Bernoulli-Greifer 1 weist ein Verbindungsstück 3 für einen nicht dargestellten steuerbaren Roboterarm auf, das mit einem Greiferkörper 4 verbunden ist. Der Greiferkörper 4 weist zwei identische Greiferkörperelemente 5 auf, die im Abstand zueinander angeordnet sind, sich parallel in Längsrichtung des rechteckförmigen Bernoulli-Greifers 1 erstrecken und mittig durch eine bügelartige Halterungseinrichtung 6 verbunden sind. An der oberen Fläche 6 der Halterungseinrichtung 6 greift das Verbindungsstück 3 für den Roboterarm an.

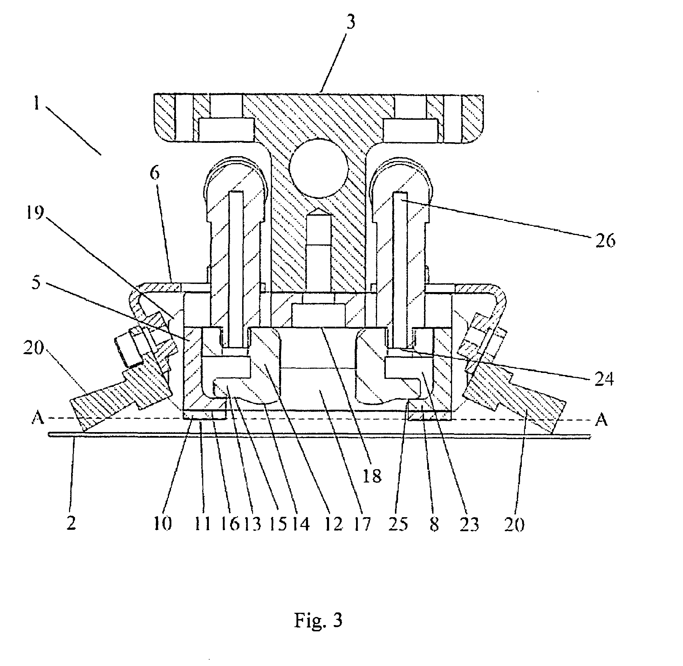

Weiterhin weist, wie am besten aus Fig. 3 ersichtlich ist, jedes Greiferkörperelement 5 des Greiferkörpers 4 an dem zur Halterungseinrichtung 6 entgegen gesetzten Ende jeweils einen zur Längsachse 7 hin gerichteten Kragen 8 auf, an dessen dem zugreifenden Wafer 2 zugewandte planen Stirnfläche 9 jeweils ein gummiertes Auflageelement 10 mit einer zum Wafer 2 gewandten Greiffläche 11 vorgesehen ist. Ein - gesehen im Querschnitt - trichterförmiges Bauelement 12 ist symmetrisch zur Längsachse 7 des rechteckförmigen Bernoulli-Greifers 1 zwischen den Greiferkörperelementen 5 des Greiferkörpers 4 angeordnet und mit diesem verbunden.

Das trichterförmige Bauelement 12 weist an seinem dem zu greifenden Wafer 2 zugewandten Ende beidseitig einen nach außen gerichteten Kragen 13 auf, der sich jeweils über die Länge des trichterförmigen Bauelementes 12 erstreckt. Die dem zu greifenden Wafer 2 zugewandte Stirnfläche 14 des trichterförmigen Bauelementes 12 ist beidseitig des letzteren konvex geformt und zur Ebene A der planen Stirnflächen 9 der Kragen 8 der Greiferkörperelemente 5 des Greiferkörpers 4 in den Bernoulli-Greifers 1 hinein versetzt. Die dem zu greifenden Wafer 2 zugewandte Fläche 15 des nach außen gerichteten Kragens 13 des trichterförmigen Bauelementes 12 verläuft beidseitig parallel zur Fläche 16 des Kragen 8 jedes Greiferkörperelementes 5, die jeweils dessen planer Stirnfläche 9 gegenüberliegt. Der Innenraum des trichterförmigen Bauelementes 12 bildet einen nach oben offenen Abzugsschacht 17, in dem ein von der Halterungseinrichtung 6 gehaltener Sensor 18 so positioniert ist, dass von ihm der zugreifenden Wafer 2 bei Anlage an der Greiffläche 10 zu erkennen ist. Der nach oben offene Abzugsschacht 17 mündet unterhalb der bügelförmigen Halterungseinrichtung 6 des Greiferkörpers 4, wie am besten aus Fig. 1 zu erkennen ist.

Fig. 1 zeigt weiterhin, dass an den in Richtung der Längsachse 7 weisenden Stirnseiten des rechteckförmigen Bernoulli-Greifer 1 jeweils eine Endplatte 19 vorgesehen ist. Die Endplatten 19 verbinden die beiden Greiferkörperelemente 5 des Greiferkörpers 4 und schließen das - gesehen im Querschnitt - trichterförmige Bauelement 12 jeweils an seinen in Richtung der Längsachse 7 des rechteckförmigen Bernoulli-Greifers 1 weisenden Stirnseiten ab.

Wie aus den Figuren 1, 3 und 5 hervorgeht, ist beidseitig der bügelartigen Halterungseinrichtung 6 des Greiferkörpers 4 jeweils ein Dämpfungselement 20 einer Dämpfungseinrichtung vorgesehen das sich jeweils über die Länge des rechteckförmigen Bernoulli-Greifers 1 erstreckt. Der Umriß der Dämpfungseinrichtung überragt - gesehen in der Draufsicht des Bernoulli-Greifers 1 - konturenmäßig alle übrigen Bauteile 3, 4, 5, 6, 10 und 12 des Bernoulli-Greifers 1 und bildet für den zu greifenden Wafer 2 in dessen zur Greiffläche 10 ansaugbedingten Anflug einen solchen Dämpfungswiderstand, dass der Wafer 2 stoßschonend an der Greiffläche 11 der Auflageelemente 10 zur Anlage kommt.

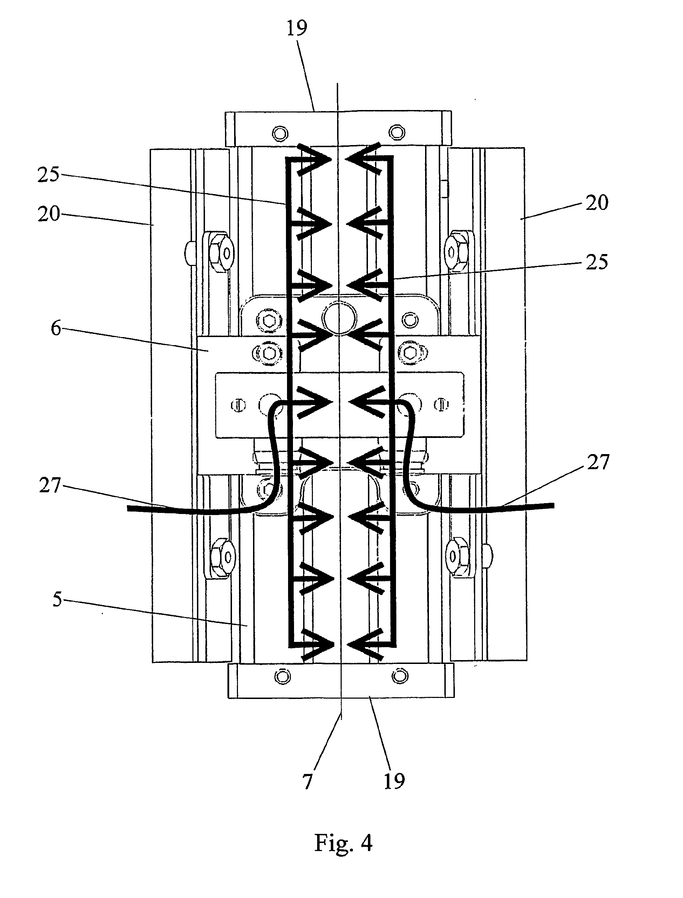

Ein Strömungssystem für Druckluft des rechteckförmigen Bernoulli-Greifers 1 weist zwei Druckluftkammern 23 auf, die im Abstand zueinander und symmetrisch zur Längsachse 7 jeweils zwischen einem Greiferkörperelement 5 des Greiferkörpers 4 und dem trichterförmigen Bauelement 12 des rechteckförmigen Bernoulli-Greifers 1 angeordnet sind und sich jeweils über die Länge des letzteren erstrecken. Die Druckluftkammern 23 weisen jeweils mindestens eine Eintrittsöffnung 24 und mindestens eine Austrittsöffnung 25, wobei sich letztere jeweils über die Länge der zugeordneten Druckluftkammer 23 des rechteckförmigen Bernoulli-Greifers 1 erstreckt, wie der Fig. 4 zu entnehmen ist.

Das Strömungssystem umfaßt weiterhin zwei Druckluftzuführungen 26, die, wie die Fig. 1, 3 und 5 zeigen, im Abstand zueinander die bügelartige Halterungseinrichtung 6 des Greiferkörpers 4 jeweils durchsetzen und jeweils mit der mindestens einen Eintrittsöffnung 24 der jeweiligen Druckluftkammer 23 verbunden sind.

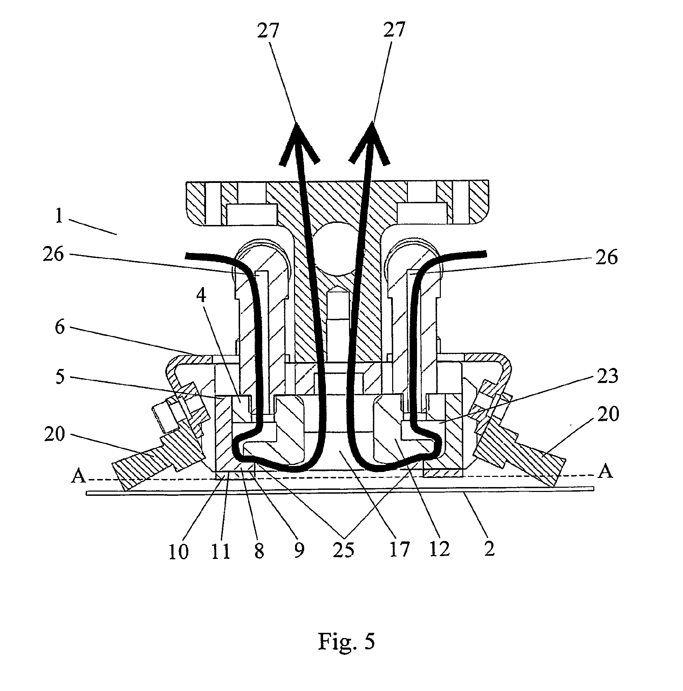

Wie die Fig. 3 und 5 am besten zeigen, ist die mindestens eine Austrittsöffnung 25 jeder Druckluftkammer 23 des rechteckigen Bernoulli-Greifers 4 jeweils zwischen der Fläche 15 jedes am trichterförmigen Bauelement 12 nach außen gerichteten Kragens 13 und der Fläche 16 des Kragens 8 des jeweiligen Greiferkörperelementes 5 gebildet, die der planen Stirnfläche 9 des Kragens 8 des jeweiligen Greiferkörperelementes 5 gegenüberliegt. Die Austrittsöffnung 25 kann in Form eines Spaltes von ca. 0,1 mm gebildet sein, der sich über die Länge der Druckkammer 23 erstreckt. Die Fläche 15 des nach außengerichteten Kragens 13 des trichterförmigen Bauelementes 12 geht jeweils - gesehen im Querschnitt des rechteckförmigen Bernoulli-Greifers 1 - abwärts geschwungen in die konvex geformten Oberfläche des Ende des trichterförmigen Bauelementes 12 über.

Bei Einführung der Druckluft in die mindestens eine Eintrittsöffnung 24 der jeweiligen Druckluftkammer 23 wird basierend auf dem Bernoulli-Prinzip ein Unterdruck an der Greiffläche 11 des zugeordneten Auflageelementes 10 zum Ansaugen des zu greifenden Wafers 2 erzeugt, indem die Druckluft in der jeweiligen Druckluftkammer 23 durch die mindestens eine Austrittsöffnung 25 beschleunigt wird.

Wie der Fig. 4 zu entnehmen ist, die die Verteilung der Druckluft innerhalb des rechteckförmigen Bernoulli-Greifers 1 zeigt, ist die mindestens eine Austrittsöffnung 25 jeder Druckluftkammer 23 über ihre Länge innerhalb des rechteckförmigen Bernoulli-Greifer 1 so ausgerichtet, dass der aus der Austrittsöffnung 25 austretende Druckluftstrom im Bernoulli-Greifer 1 über die Länge der Druckluftkammer 23 jeweils einwärts zur Längsachse 7 des Bernoulli-Greifers 1 hin gerichtet ist.

Fig. 5 zeigt, dass bei durch den Bernoulli-Effekt angesaugtem Wafer 2 an der Greiffläche 11 jedes Auflageelementes 10 der aus der mindestens einen Austrittsöffnung 25 jeder Druckluftkammer 23 kommende Druckluftstrom jeweils einwärts zur Längsachse 7 des Bernoulli-Greifers 1 hin gerichtet ist, an der Fläche 15 des nach außen gerichteten Kragens 13 des trichterförmigen Bauelementes 12 einwärts strömt, bis er um das konvex geformte Ende des trichterförmigen Bauelementes 12 herum in den nach oben offenen Abzugsschacht 17 gelenkt, dann in diesem innerhalb des Bernoulli-Greifers 1 aufwärts geführt und schließlich aus letzterem nach oben abgeführt wird.

Durch die zuvor beschriebene und in Fig. 5 durch den jeweiligen Pfeil gekennzeichnete Strömungsführung 27 der aus der mindestens einen Ausführungsöfnung 25 jeder Druckluftkammer 23 strömenden Druckluft innerhalb des Bernoulli-Greifers 1 zur Außenatmosphäre hin bleibt der Bernoulli-Greifer 1 an seiner Peripherie von Abluft unberührt, wodurch eine Beeinträchtigung oder Beschädigung von Wafern 2, die sich in unmittelbarer Nachbarschaft zum Bernoulli-Greifer 1 befinden, vermieden wird. Soll der Bereich über dem Bernoulli-Greifer 1 frei von Abluft bleiben, so kann diese über einen Absaugschlauch oder über ein entsprechendes Absaugsystem abtransportiert werden, der bzw. das an den nach oben offenen Abzugsschacht 17 anzuschließen ist.

### Liste der Bezugszeichen:

- **1**: Bernoulli-Greifer
- **2**: Wafer
- **3**: Verbindungsstück für einen Roboterarm
- **4**: Greiferkörper
- **5**: Greiferkörperelemente
- **6**: Bügelartige Halterungseinrichtung
- **7**: Längsachse des rechteckförmigen Bernoulli-Greifers
- **8**: Kragen des Greiferkörperelementes
- **9**: Stirnfläche des Kragens des Greiferkörperelementes
- **10**: Gummiertes Auflageelement, Auflagering mit gummierter Auflagefläche
- **11**: Greiffläche
- **12**: Trichterförmiges Bauelement
- **13**: Nach außen gerichteter Kragen des trichterförmigen Bauelementes
- **14**: Stirnfläche des Endes des trichterförmigen Bauelementes
- **15**: Fläche des nach außen gerichteten Kragens des trichterförmigen Bauelementes
- **16**: Der Stirnfläche des Kragens des Greiferkörperelementes gegenüberliegende Fläche
- **17**: Nach oben offener Abzugsschacht
- **18**: Sensor
- **19**: Endplatten
- **20**: Dämpfungselemente
- **23**: Druckluftkammer
- **24**: Eintrittsöffnung der Druckluftkammer
- **25**: Austrittsöffnung der Druckluftkammer
- **26**: Druckluftzuführung
- **27**: Pfeil des Strömungsverlaufs der Luft im Bernoulli-Greifer
- **31**: Halterungsrahmen
- **A**: Ebene der Greiffläche des Auflageelementes

## Patentansprüche

1. Bernoulli-Greifervorrichtung mit mindestens einem eine rechteckförmige Grundrißkontur aufweisenden Bernoulli-Greifer (1) zur Aufnahme von flächigen Substraten wie siliziumbasierten Wafern (2), der aufweist:
einen mit einem Verbindungsstück (3) für einen Roboterarm verbundenen Greiferkörper (4), mit dem ein - gesehen im Querschnitt des Bernoulli-Greifers (1) - trichterförmiges Bauelement (12) und mindestens ein gummiertes Auflageelement (10) mit einer Greiffläche (11) verbunden ist, durch die ein rutschfestes Verfahren eines an letzterer angesaugten Substrats (2) gegeben ist,
der zwei sich parallel in Längsrichtung des rechteckförmigen Bernoulli-Greifers (1) erstreckende identische Greiferkörperelemente (5) aufweist, die im Abstand zueinander angeordnet und mittig durch eine Halterungsvorrichtung (6) verbunden sind, an der das Verbindungsstück (3) für den Roboterarm angreift und
zwischen dessen Greiferkörperelementen (5) das - gesehen im Querschnitt - trichterförmige Bauelement (12) symmetrisch zur Längsachse (7) des Bernoulli-Greifers (1) angeordnet ist, sich über die Länge des letzteren erstreckt und einen nach oben offenen Abzugsschacht (17) umfasst, der sich ebenfalls über die Länge des Bernoulli-Greifers (1) erstreckt,
eine an dem Greiferkörper (4) außen adaptierte Dämpfungseinrichtung, deren Umriß - gesehen im Querschnitt des Bernoulli-Greifers (1) - alle übrigen Bauteile (4, 5, 10, 12) des Bernoulli-Greifers (1) konturenmäßig überragt und die für das zu greifende Substrat (2) in dessen zur Greiffläche (11) ansaugbedingten Anflug einen solchen Dämpfungswiderstand bildet, dass das Substrat (2) stoßschonend an der Greiffläche (11) des mindestens einen Auflageelementes (10) anzulegen ist
ein Strömungssystem (26, 24, 23, 25) für Druckluft, das zwei im Abstand zueinander und jeweils zwischen einem der beiden Greiferkörperelemente (5) und dem trichterförmigen Bauelement (12) angeordnete, sich jeweils über dessen Länge erstreckende Druckluftkammern (23) mit jeweils mindestens einer Eintrittsöffnung (24) und mindestens einer Austrittsöffnung (25) sowie mindestens zwei Druckluftzuführungen aufweist, die jeweils mit der mindestens einen Eintrittsöffnung (24) der jeweils zugeordneten Druckluftkammer (23) verbunden sind, wobei
die mindestens eine Austrittsöffnung (25) jeder Druckluftkammer (23) sich jeweils über die Länge letzterer erstreckt und innerhalb des Bernoulli-Greifers (1) so ausgerichtet ist, dass der aus der mindestens einen Austrittsöffnung (25) austretende Druckluftstrom über deren Länge jeweils einwärts zur Längsachse (7) des Bernoulli-Greifers (1) hin gerichtet ist und mit der Greiffläche (11) des mindestens einen Auflageelementes (10) derart kommuniziert, dass bei Einführung der Druckluft in die mindestens eine Eintrittsöffnung (24) des Strömungssystems (23, 24, 25, 26) ein Unterdruck an der Greiffläche (11) des mindestens einen Auflageelementes (10) zum Ansaugen des zu greifenden Substrats (2) zu erzeugen ist, und wobei
der von der jeweils mindestens einen Austrittsöffnung (25) jeder Druckluftkammer (26) einwärts zur Längsachse (7) des Bernoulli-Greifers (1) hin gerichtete Druckluftstrom in den nach oben offenen Abzugsschacht (17) zu lenken, in diesem im Bernoulli-Greifer (1) aufwärts zu führen und aus letzterem nach außen abzuführen ist.

2. Bernoulli-Greifervorrichtung Anspruch 1, **dadurch gekennzeichnet, dass** gesehen im Querschnitt des Bernoulli-Greifers (1) - jedes Greiferkörperelement (5) an seinem dem zu greifenden Substrat (2) zugewandten Ende einen zu diesem rechtwinkligen und zur Längsachse (7) des Bernoulli-Greifers (1) hin gerichteten Kragen (8) und das trichterförmige Bauelement (12) an seinem dem zu greifenden Substrat (2) zugewandten Ende an beiden Längsseiten einen nach außen gerichteten Kragen aufweisen, dessen Ende jeweils oberhalb des Kragen (8) des zugeordneten Greiferkörperelementes (5) derart im Bernoulli-Greifer (1) positioniert ist, dass die jeweils mindestens eine Austrittsöffnung (25) jeder Druckluftkammer (25) zwischen der dem zu greifenden Substrat (2) zugewandten planen Fläche 15 des nach außen gerichteten Kragens (13) des trichterförmigen Bauelementes (12) und der planen Fläche (16) des Kragens (8) des zugeordneten Greiferkörperelementes (5) gebildet ist, die zur Fläche (15) des nach außen gerichteten Kragens (13) des trichterförmigen Bauelementes (12) parallel und dieser zugewandt ist.

3. Bernoulli-Greifervorrichtung nach Anspruch 1 oder 2 , **dadurch gekennzeichnet, dass** an der planen Stirnfläche (9) des Kragens (8) jedes Greifkörperelementes (5) jeweils ein gummiertes Auflageelement (10) mit einer Greiffläche (11) für das zu greifende Substrat (2) vorgesehen ist, wobei die beiden Greifflächen (11) in einer Ebene (A) liegen.

4. Bernoulli-Greifervorrichtung nach einem der vorhergehenden Ansprüche, **dadurch gekennzeichnet, dass** das dem zu greifenden Substrat (2) zugewandte beidseitige Ende des trichterförmigen Bauelementes (12) in Bezug zur Ebene (A) der Greifflächen .(11) der Auflageelemente (10) in Richtung senkrecht zur Längsachse (7) des Bernoulli-Greifers (1) in diesen nach innen versetzt angeordnet ist.

5. Bernoulli-Greifervorrichtung nach einem der vorhergehenden Ansprüche, **dadurch gekennzeichnet, dass** - gesehen im Querschnitt des Bernoulli-Greifers (1) - die Oberfläche des dem zu greifenden Substrat (2) zugewandten beidseitigen Endes des trichterförmigen Bauelementes (12) konvex geformt ist und konkav geschwungen in die Fläche 15 des zugeordneten nach außen gerichteten Kragens (13) des trichterförmigen Bauelementes (12) übergeht,
wobei bei der durch den Bernoulli-Effekt bedingten Anlage des Substrats an der Greiffläche (11) jedes Auflageelementes (10) jeweils der Druckluftstrom aus der mindestens einen Austrittsöffnung (25) jeder Druckluftkammer (23) an der Fläche (15) des zugeordneten nach außen gerichteten Kragens (13) des trichterförmigen Bauelementes (12) entlang einwärts zur Längsachse (7) des Bernoulli-Greifers (1) hin zur konvex geformten Oberfläche des zugeordneten Endes des trichterförmigen Bauelementes (12) und um letzteres herum in den nach oben offenen Abzugsschacht (17) hinein und im Bernoulli-Greifer (1) aufwärts zu führen sowie aus letzterem abzuführen ist.

6. Bernoulli-Greifervorrichtung nach einem der vorhergehenden Ansprüche, **dadurch gekennzeichnet, dass** eine Vielzahl der Bernoulli-Greifer (1) in einer beliebigen Mehrfach-Bernoulli-Greiferkonfiguration angeordnet ist.

7. Bernoulli-Greifervorrichtung nach einem der vorhergehenden Ansprüche, **dadurch gekennzeichnet, dass** die Vielzahl der Bernoulli-Greifer (1) matrixartig an einem Halterungsrahmen (31) vorgesehen ist.

8. Bernoulli-Greifervorrichtung nach Anspruch 6 oder 7, **dadurch gekennzeichnet, dass** die einzelnen Strömungssysteme der Vielzahl der Bernoulli-Greifer (1) synchron oder asynchron über die jeweiligen Druckluftzuführungen (26) anzusteuern sind.

## Claims

1. A Bernoulli gripper device having at least one Bernoulli gripper (1) provided with a rectangular contour in plan view for picking up planar substrates such as silicon-based wafers (2), which comprises:
a gripper body (4) connected to a connecting piece (3) for a robotic arm, the gripper body being connected to a funnel-shaped component (12) - as viewed in the cross section of the Bernoulli gripper (1) - and at least one rubberized support element (10) having a gripping surface (11), thereby ensuring non-slip displacement of a substrate (2) aspirated onto the latter;
two identical, parallel gripper body elements (5) extending in the longitudinal direction of the rectangular Bernoulli gripper (1), disposed at a distance from each other and connected centrally by means of a holding device (6) on which the connecting piece (3) for the robotic arm engages; and
the funnel-shaped component (12) - as viewed in cross section - is disposed symmetrically with respect to the longitudinal axis (7) of the Bernoulli gripper (1) between said gripper body elements (5), extends over the length of the Bernoulli gripper and comprises an exhaust duct (17) which is open at the top, which also extends over the length of the Bernoulli gripper (1);
a cushioning device which is adapted to the outside of the gripper body (4), with a contour - as viewed in the cross section of the Bernoulli gripper (1) - which protrudes beyond the contours of all of the remaining components (4, 5, 10, 12) of the Bernoulli gripper (1) and which develops a cushioning resistance to the approach of the substrate (2) to be gripped towards the gripping surface (11) under the effect of aspiration such that the substrate (2) can be applied gently to the gripping surface (11) of the at least one support element (10);
a flow system (26, 24, 23, 25) for compressed air, which comprises two compressed air chambers (23) which are separated from each other and each disposed between one of the two gripper body elements (5) and the funnel-shaped component (12), each extending over the length thereof, each comprising at least one inlet opening (24) and at least one outlet opening (25) as well as at least two compressed air supply lines which are respectively connected to the at least one inlet opening (24) of the respective associated compressed air chamber (23); wherein
the at least one outlet opening (25) of each compressed air chamber (23) respectively extends over the length thereof and is orientated within the Bernoulli gripper (1) such that the flow of compressed air out of the at least one outlet opening (25) over its length is respectively directed inwardly towards the longitudinal axis (7) of the Bernoulli gripper (1) and communicates with the gripping surface (11) of the at least one support element (10) such that on introducing the compressed air into the at least one inlet opening (24) of the flow system (23, 24, 25, 26), a negative pressure is produced on the gripping surface (11) of the at least one support element (10) in order to aspirate the substrate (2) to be gripped; and wherein
the flow of compressed air from each respective at least one outlet opening (25) of each compressed air chamber (26) which is directed inwardly towards the longitudinal axis (7) of the Bernoulli gripper (1) is guided into the exhaust duct (17) which is open at the top and conducted upwards therein within the Bernoulli gripper (1) and discharged out of it.

2. A Bernoulli gripper device as claimed in claim 1, **characterized in that** - as viewed in the cross section of the Bernoulli gripper (1) - the end of each gripper body element (5) facing the substrate to be gripped has a collar (8) directed away from the longitudinal axis (7) of the Bernoulli gripper (1) at right angles thereto and the end of the funnel-shaped component (12) facing the substrate (2) to be gripped is provided, at both longitudinal sides, with an outwardly directed collar, the respective end of which is positioned in the Bernoulli gripper (1) above the collar (8) of the associated gripper body element (5) in such a manner that the respective at least one outlet opening (25) of each compressed air chamber (25) is formed between the flat surface (15) of the outwardly directed collar (13) of the funnel-shaped component (12) facing the substrate (2) to be gripped and the flat surface (16) of the collar (8) of the associated gripper body element (5) which is parallel to and facing surface (15) of the outwardly directed collar (13) of the funnel-shaped component (12).

3. The Bernoulli gripper device as claimed in claim 1 or claim 2, **characterized in that** a respective rubberized support element (10) with a surface (11) for gripping the substrate (2) to be gripped is provided on the flat forepart (9) of the collar (8) of each gripper body element (5), wherein the two gripping surfaces (11) lie in a plane (A).

4. The Bernoulli gripper device as claimed in one of the preceding claims, **characterized in that** the double sided end of the funnel-shaped component (12) facing the substrate (2) to be gripped is offset inwardly with respect to the plane (A) of the gripping surfaces (11) of the support element (10) in a direction perpendicular to the longitudinal axis (7) of the Bernoulli gripper (1).

5. The Bernoulli gripper device as claimed in one of the preceding claims, **characterized in that** - as viewed in the cross section of the Bernoulli gripper (1) - the surface of the double sided end of the funnel-shaped component (12) facing the substrate (2) to be gripped is convex in shape and blends into a concave curve of the surface (15) of the associated outwardly directed collar (13) of the funnel-shaped component (12);
wherein, when the substrate becomes positioned on the gripping surface (11) of each support element (10) under the Bernoulli effect, the respective flow of compressed air out of the at least one outlet opening (25) from each compressed air chamber (23) is guided onto and along the surface (15) of the associated outwardly directed collar (13) of the funnel-shaped collar (12), inwards towards the longitudinal axis (7) of the Bernoulli gripper (1) towards the convexly shaped surface of the associated end of the funnel-shaped component (12) and round the latter into the exhaust duct (17) which is open at the top and upwards in the Bernoulli gripper (1), and then discharged therefrom.

6. The Bernoulli gripper device as claimed in one of the preceding claims, **characterized in that** a plurality of Bernoulli grippers (1) is arranged in any configuration of multiple Bernoulli grippers.

7. The Bernoulli gripper device as claimed in one of the preceding claims, **characterized in that** the plurality of Bernoulli grippers (1) is arranged as a matrix on a holding frame (31).

8. The Bernoulli gripper device as claimed in claim 6 or claim 7, **characterized in that** the individual flow systems of the plurality of Bernoulli grippers (1) are controlled synchronously or asynchronously via the respective compressed air supply lines (26).

## Revendications

1. Dispositif préhenseur à effet Bernoulli avec au moins un préhenseur à effet Bernoulli (1) présentant un contour plan rectangulaire pour recevoir des substrats plats comme des galettes à base de silicium (2), qui présente :
un corps de préhenseur (4) associé à une pièce de liaison (3) pour un bras de robot, avec lequel un élément de construction (12) - vu en coupe du préhenseur à effet Bernoulli (1) - en forme de trémie et au moins un élément d'appui caoutchouté (10) est raccordé à une surface de préhension (11) par laquelle est permis un déplacement antidérapant d'un substrat (2) aspiré sur cette dernière,
qui présente deux éléments de corps de préhenseur (5) identiques s'étendant parallèlement dans le sens longitudinal du préhenseur à effet Bernoulli rectangulaire (1), qui sont disposés à distance l'un de l'autre et raccordés centralement par un dispositif de fixation (6) sur lequel vient en prise une pièce de liaison (3) pour le bras de robot et
entre les éléments de corps de préhenseur (5) desquels, l'élément de construction (12) en forme de trémie - vu en coupe - est disposé symétriquement à l'axe longitudinal (7) du préhenseur à effet Bernoulli (1), s'étend sur la longueur de ce dernier et comprend une cage d'extraction (17) ouverte vers le haut qui s'étend également sur la longueur du préhenseur à effet Bernoulli (1),
un dispositif d'amortissement adapté extérieurement au corps de préhenseur (4) dont le périmètre - vu en coupe du préhenseur à effet Bernoulli (1) - dépasse tous les autres composants (4, 5, 10, 12) du préhenseur à effet Bernoulli (1) conformément au contour et qui constitue pour le substrat (2) à saisir dans son approche conditionnée par aspiration de la surface de préhension (11) une résistance d'amortissement telle que le substrat (2) peut être posé avec ménagement au choc sur la surface de préhension (11) d'au moins un élément d'appui (10),
un système d'écoulement (26, 24, 23, 25) pour l'air comprimé qui présente deux chambres d'air comprimé (23) à distance l'une de l'autre et disposées respectivement entre un des deux éléments de corps de préhenseur (5) et l'élément de construction (12) en forme de trémie, s'étendant à chaque fois sur la longueur de celui-ci, avec respectivement au moins une ouverture d'entrée (24) et au moins une ouverture de sortie (25) ainsi qu'au moins deux alimentations en air comprimé, qui sont reliées respectivement avec au moins une ouverture d'entrée (24) des chambres d'air comprimé (23) respectivement affectée, pour lequel
les au moins une ouverture de sortie (25) de chaque chambre d'air comprimé (23) s'étend respectivement sur la longueur de cette dernière et est orientée à l'intérieur du préhenseur à effet Bernoulli (1) de telle sorte que le flux d'air comprimé sortant d'au moins une ouverture de sortie (25) est dirigé sur la longueur de celle-ci à chaque fois en dedans dans l'axe longitudinal (7) du préhenseur à effet Bernoulli (1) et communique avec la surface de préhension (11) d'au moins un élément d'appui (10) de telle sorte que lors de l'entrée de l'air comprimé dans au moins une ouverture d'entrée (24) du système d'écoulement (23, 24, 25, 26), une dépression est produite sur la surface de préhension (11) d'au moins un élément d'appui (10) pour aspiration du substrat (2) à saisir et pour lequel
le flux d'air comprimé orienté par à chaque fois au moins une ouverture de sortie (25) de chaque chambre d'air comprimé (26) vers l'intérieur dans l'axe longitudinale (7) du préhenseur à effet Bernoulli (1) est dirigé dans la cage d'extraction (17) ouverte vers le haut, est guidé dans celle-ci vers le haut dans le préhenseur à effet Bernoulli (1) et est évacué de cette dernière vers l'extérieur.

2. Dispositif préhenseur à effet Bernoulli selon la revendication 1, **caractérisé en ce que**, - vu en coupe du préhenseur à effet Bernoulli (1) -, chaque élément de corps de préhenseur (5) à son extrémité tournée vers le substrat (2) à saisir présente une collerette (8) orientée vers celle-ci perpendiculaire et dans l'axe longitudinal (7) du préhenseur à effet Bernoulli (1) et l'élément de construction (12) en forme de trémie présente à son extrémité tournée vers le substrat (2) à saisir sur les deux côtés longitudinaux une collerette orientée vers l'extérieur, dont l'extrémité est à chaque fois positionnée au-dessus de la collerette (8) de l'élément de corps de préhenseur (5) affecté dans le préhenseur à effet Bernoulli (1) de telle sorte qu'à chaque fois les au moins une ouverture de sortie (25) de chaque chambre d'air comprimé (23) est constituée entre la surface (15) plane tournée vers le substrat (2) à saisir de la collerette (13) orientée vers l'extérieure de l'élément de construction (12) en forme de trémie et la surface (16) plane de la collerette (8) de l'élément de corps de préhenseur (5) affecté qui est parallèle à la surface (15) de la collerette (13) orientée vers l'extérieur de l'élément de construction (12) en forme de trémie et tournée vers celle-ci.

3. Dispositif préhenseur à effet Bernoulli selon la revendication 1 ou 2, **caractérisé en ce que** sur la surface frontale (9) plane de la collerette (8) de chaque élément de corps de préhenseur (5) est respectivement prévu un élément d'appui (10) caoutchouté avec une surface de préhension (11) pour le substrat (2) à saisir, les deux surfaces de préhension (11) se trouvant dans un plan (A).

4. Dispositif préhenseur à effet Bernoulli selon une quelconque des revendications précédentes, **caractérisé en ce que** l'extrémité bilatérale tournée vers le substrat (2) à saisir de l'élément de construction (12) en forme de trémie est disposée, par rapport au plan (A) des surfaces de préhension (11) des éléments d'appui (10) dans un sens perpendiculaire à l'axe longitudinal (7) du préhenseur à effet Bernoulli (1), déportée dans celui-ci vers l'intérieur.

5. Dispositif préhenseur à effet Bernoulli selon une quelconque des revendications précédentes, **caractérisé en ce que** - vue en coupe du préhenseur à effet Bernoulli (1) - la surface de l'extrémité bilatérale tournée vers le substrat (2) à saisir de l'élément de construction (12) en forme de trémie est formé de façon convexe et passe cintrée de façon concave dans la surface (15) de la collerette (13) affectée orientée vers l'extérieur de l'élément de construction (12) en forme de trémie, pour lequel, pour l'installation conditionnée par l'effet de Bernoulli du substrat à la surface de préhension (11) de chaque élément d'appui (10), le flux d'air comprimé doit être à chaque fois guidé depuis au moins une des ouvertures de sortie (25) de chaque chambre d'air comprimé (23) à la surface (15) de la collerette (13) affectée orientée vers l'extérieur de l'élément de construction (12) en forme de trémie le long de l'axe longitudinal (7) vers l'intérieur du préhenseur à effet Bernoulli (1) vers la surface formée convexe de l'extrémité affectée de l'élément de construction (12) en forme de trémie et autour de ce dernier dans la cage d'extraction (17) ouverte vers le haut et vers le haut dans le préhenseur à effet Bernoulli (1) ainsi qu'évacué de ce dernier.

6. Dispositif préhenseur à effet Bernoulli selon une quelconque des revendications précédentes, **caractérisé en ce qu'**une pluralité de préhenseurs à effet Bernoulli (1) est disposée dans une configuration de préhenseurs à effet Bernoulli multiple quelconque.

7. Dispositif préhenseur à effet Bernoulli selon une quelconque des revendications précédentes, **caractérisé en ce que** la pluralité de préhenseurs à effet Bernoulli (1) est prévue de type matriciel sur un cadre de fixation (31).

8. Dispositif préhenseur à effet Bernoulli selon la revendication 6 ou 7, **caractérisé en ce que** les systèmes d'écoulement individuels de la pluralité de préhenseurs à effet Bernoulli (1) peuvent être commandés de façon synchrone ou asynchrone par les alimentations d'air comprimé (26) respectives.
